Europäisches Patentamt

European Patent Office

Office européen des brevets

(11) Numéro de publication: **0 305 265**

**A1**

## (12) DEMANDE DE BREVET EUROPEEN

(21) Numéro de dépôt: **88402085.0**

(22) Date de dépôt: **10.08.88**

(51) Int. Cl.⁴: **H 04 B 3/54**
H 03 B 5/12

(30) Priorité: **11.08.87 FR 8711423**

(43) Date de publication de la demande:
**01.03.89 Bulletin 89/09**

(84) Etats contractants désignés:
**AT BE CH DE ES GB GR IT LI LU NL SE**

(71) Demandeur: **Sté TEXTON**
**232 rue de Noisy le Sec**
**F-93170 Bagnolet (FR)**

(72) Inventeur: **Rolland, Michel**
**162 rue de Rosny**
**F-93100 Montreuil (FR)**

**Martin, Jean-Pierre**
**16 rue de la Victoire**
**F-44110 Chateaubriant (FR)**

(74) Mandataire: **Berger, Helmut et al**
**Cabinet Z. WEINSTEIN 20, avenue de Friedland**
**F-75008 Paris (FR)**

(54) Dispositif de transmission d'informations électriques.

(57) L'invention concerne un dispositif de transmission d'informations entre différentes parties électriques de véhicules, engins ou machines ayant une source d'énergie électrique commune, tel qu'un accumulateur ou tout autre source d'énergie possédant une capacité interne et en ce qu'il comporte en série avec la source d'alimentation comportant une capacité interne C1, une inductance L1 constituant un circuit de résonance avec ladite capacité C1 d'une fréquence prédéterminée correspondant à la fréquence de l'information à transmettre.

_Fig. 1_

EP 0 305 265 A1

Bundesdruckerei Berlin

# Description

## Dispositif de transmission d'informations électriques.

L'invention concerne un dispositif de transmission d'informations électriques entre différentes parties électriques d'un objet tel qu'un véhicule automobile, ou machine, ayant une source d'énergie commune, telle qu'une batterie d'accumulateur, possédant une capacité interne.

Il est déjà connu de réaliser des transmissions d'informations via des circuits électriques. Parmi les dispositifs connus à ce jour, on peut citer principalement les interphones secteur. Ces dispositifs qui donnent satisfaction dans certaines conditions d'utilisation sont cependant inefficaces lorsqu'une batterie ou une autre source d'énergie présentant une capacité interne est intercalée entre l'émetteur et le récepteur des informations. En effet, toute source d'énergie possédant une capacité interne représente un mur infranchissable au passage de toutes les fréquences électriques.

La présente invention a pour but de remédier à ces inconvénients en fournissant un dispositif de construction simple et fiable.

Pour atteindre ce but, le dispositif selon l'invention est caractérisé en ce que le trajet de transmission des informations entre lesdites parties est formé par le circuit électrique d'alimentation en énergie reliant lesdites parties à ladite source commune et en ce qu'à ladite source est associée au moins une inductance qui forme avec ladite capacité interne un circuit de résonance dont la fréquence de résonance correspond à la fréquence d'une information à transmettre.

Selon une caractéristique avantageuse du dispositif selon l'invention, celui-ci comprend plusieurs inductances montées en parallèle pour permettre la transmission de plusieurs informations à des fréquences différentes correspondantes.

L'invention sera mieux comprise et d'autres buts, caractéristiques, détails et avantages de celle-ci apparaîtront plus clairement au cours de la description explicative qui va suivre faite en référence aux dessins annexés donnés uniquement à titre d'exemple illustrant un mode de rélisation de l'invention et dans lequel :

La figure 1 montre sous forme d'un schéma-bloc un système de transmission d'informations, équipé d'un dispositif selon l'invention, sous forme d'un schéma-bloc, et

La figure 2 donne le schéma d'un cas d'utilisation d'un dispositif selon l'invention.

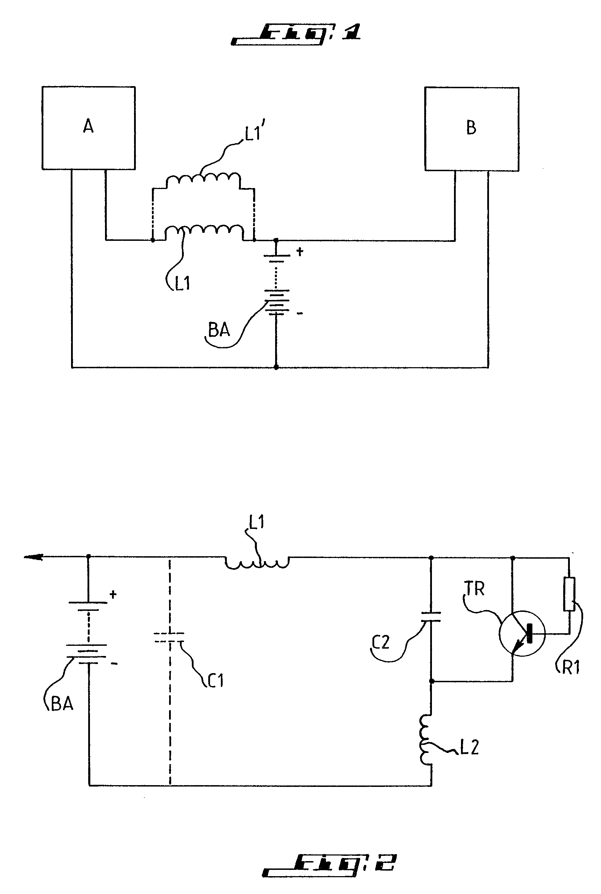

La figure 1 montre à titre d'exemple deux parties électriques A, B d'un objet tel que par exemple un véhicule automobile ou analogue, qui sont alimentées en énergie électrique à partir d'une source d'énergie commune, telle que la batterie BA du véhicule. Comme cela est bien connu, la capacité interne de cette batterie empêche une transmission des informations entre les deux parties A et B à travers les circuits reliant la batterie BA à ces parties. Pour éliminer l'influence néfaste de cette capacité interne, qui est représentée à la figure 2 en traits interrompus en C1, on prévoit dans le circuit reliant aux figures la borne positive de la batterie BA aux parties A ou B au moins une inductance L1. Celle-ci forme avec la capacité interne C1 un circuit de résonance dont la fréquence correspond à celle de la fréquence de l'information à transmettre. Comme le montre la figure, on pourrait monter en parallèle sur l'inductance L1 une ou plusieurs autres inductances symbolisées par l'inductance L1' pour assurer la transmission entre les parties A et B des informations présentant des fréquences différentes.

Sur la figure, les inductances sont représentées comme étant situées à côté de la batterie. Bien entendu, en réalité, elles seront avantageusement disposées dans la partie émettrice, à la sortie, ou à toute autre emplacement propice.

La figure 2 montre un cas d'utilisation du dispositif selon l'invention, dans lequel par exemple la partie B est formée par un montage oscillateur comprenant un transistor TR dont le circuit de base comporte une résistance de polarisation R1 tandis que l'émetteur est relié, d'une part, au collecteur par un condensateur C2 destiné à entretenir l'oscillation et, d'autre part, par une inductance L2 à la borne négative de la batterie BA. On constate qu'une inductance L1 est montée entre la borne positive de la batterie BA et le collecteur du transistor. Cette inductance L1 constitue avec la capacité interne C1 de la batterie un circuit de résonance dont la fréquence correspond à celle du montage oscillateur.

Il ressort de la description précédente de l'invention, que celui-ci propose un dispositif qui permet un échange d'informations entre différentes parties électriques par exemple d'un véhicule automobile, sans qu'il soit nécessaire de les relier par des fils conducteurs supplémentaires.

La transmission des informations se fait à travers le circuit d'alimentation d'énergie électrique reliant ces parties à la batterie du véhicule. Ainsi, on peut faire passer de multiples informations, en prévoyant, le cas échéant, plusieurs inductances parallèles, dans un seul fil conducteur ayant déjà une fonction de puissance et étant ou non en service. L'invention permet de faire fonctionner tout appareillage électrique en utilisant un circuit existant et qui ne lui était pas destiné à l'origine.

## Revendications

1. Dispositif de transmission d'informations électriques entre différentes parties électriques d'un objet tel qu'un véhicule automobile ou machine, alimenté en énergie électrique à partir d'une source d'énergie commune, telle que la batterie d'accumulateur d'un véhicule, possédant une capacité interne, caractérisé en ce que le trajet de transmission des informations entre lesdites parties (A) et (B) est formé par les circuits électriques d'alimentation en énergie électrique, reliant les parties à ladite source d'énergie commune, telle que la batterie (BA), et en ce que ladite source (BA) est associée à une inductance (L1, L1′) qui forme avec ladite capacité interne (C1) un circuit de résonance dont la fréquence de résonance correspond à la fréquence d'une information à transmettre.

2. Dispositif selon la revendication 1, caractérisé en ce qu'il comprend plusieurs inductances (L1, L1′) montées en parallèle pour permettre la transmission d'informations à des fréquences différentes.

3. Dispositif selon l'une des revendications 1 ou 2, caractérisé en ce que l'inductance (L1) est montée dans le circuit reliant la borne positive de la source d'énergie (BA) à la borne d'alimentation positive d'une des parties précitées (A, B).

4. Dispositif selon la revendication 3, caractérisé en ce que, quand la partie émettrice d'une information est formée par un montage oscillateur comportant un transistor (TR) monté en oscillateur, l'inductance (L1) est montée dans le circuit reliant la borne positive de la batterie (BA) au collecteur du transistor, ce dernier comprenant avantageusement un condensateur (C1) destiné à entretenir l'oscillation, entre le collecteur et l'émetteur. une inductance (L2) entre l'émetteur et la borne négative de la batterie (BA) et une résistance de polarisation (R1) entre la base et le collecteur du transistor (TR).

Fig. 1

Fig. 2

Office européen
des brevets

RAPPORT DE RECHERCHE EUROPEENNE

Numero de la demande

EP 88 40 2085

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | US-A-4 463 341 (IWASAKI)<br>* Colonne 3, lignes 14-63 *<br>--- | 1,3 | H 04 B 3/54<br>H 03 B 5/12 |
| A | US-A-4 072 926 (SHIMAHARA)<br>* Colonne 5, lignes 56-60; colonne 7, ligne 51 - colonne 8, ligne 37 *<br>--- | 1 | |
| A | DE-B-1 207 886 (SIEMENS)<br>* Colonne 3, lignes 1-38 *<br>----- | 4 | |

**DOMAINES TECHNIQUES RECHERCHES (Int. Cl.4)**

H 04 B
H 03 B
B 60 R
B 60 C

Le présent rapport a été établi pour toutes les revendications

| Lieu de la recherche | Date d'achèvement de la recherche | Examinateur |
|---|---|---|
| LA HAYE | 10-11-1988 | HOLPER G.E.E. |

EPO FORM 1503 03.82 (P0402)